# EUROPEAN PATENT APPLICATION

(11) **EP 2 642 528 A1**
(43) Date of publication of application: **25.09.2013**
(21) Application number: 11840801.2
(22) Date of filing: 15.11.2011
(51) Int. Cl.: H01L 31/04, H01L 21/225

(54) **METHOD FOR PRODUCING SOLAR CELL**

(30) Priority: 17.11.2010 JP 2010257167
(71) Applicant: Hitachi Chemical Co., Ltd., Chiyoda-ku Tokyo 100-6606 (JP)
(72) Inventor: MACHII, Yoichi, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); OKANIWA, Kaoru, Tsukuba-shi Ibaraki 300-4247 (JP); IWAMURO, Mitsunori, Tsukuba-shi Ibaraki 300-4247 (JP); ADACHI, Shuichirou, Tsukuba-shi Ibaraki 300-4247 (JP); ORITA, Akihiro, Tsukuba-shi Ibaraki 300-4247 (JP); SATO, Tetsuya, Tsukuba-shi Ibaraki 300-4247 (JP); KIZAWA, Keiko, Tsukuba-shi Ibaraki 300-4247 (JP)
(74) Representative: HOFFMANN EITLE
(86) International application number: PCT/JP2011/076313
(87) International publication number: WO 2012/067119

(57) **Abstract**

The method for producing a photovoltaic cell includes a process of applying an n-type diffusion layer forming composition including an n-type impurity-containing glass powder and a dispersion medium onto a first region on one surface side of a semiconductor substrate; a process of applying a p-type diffusion layer forming composition including a p-type impurity-containing glass powder and a dispersion medium onto a second region other than the first region on the surface of the semiconductor substrate where the first region is provided; a thermal diffusion process in which an n-type diffusion layer and a p-type diffusion layer are formed by heat-treating the semiconductor substrate onto which the n-type diffusion layer forming composition and the p-type diffusion layer forming composition are applied; and a process of forming an electrode on each of the first region where the n-type diffusion layer is formed and the second region where the p-type diffusion layer is formed, respectively.

## Description

### Technical Field

The present invention relates to a method for producing a photovoltaic cell.

### Background Art

A double-sided electrode type photovoltaic cell in which an n-electrode is formed on a light receiving surface of a silicon substrate and a p-electrode is formed on a rear surface of the silicon substrate accounts for the majority of currently produced photovoltaic cells. However, in regard to the double-sided electrode type photovoltaic cell, solar light is not incident to the silicon substrate directly under an n-electrode that is formed on the light receiving surface, such that a current is not generated at that portion.
Therefore, a rear surface electrode type photovoltaic cell in which an electrode is not provided in a light receiving surface of a photovoltaic cell, and both of the n-electrode and the p-electrode are provided on a rear surface that is opposite to the light receiving surface is suggested. In such a rear surface electrode type photovoltaic cell, the incidence of the solar light is not obstructed by an electrode formed on the light receiving surface, such that a high conversion efficiency may be expected in principle.

As a method of manufacturing the rear surface electrode type photovoltaic cell, for example, the following manufacturing method is known (For example, refer to Specification of US patent No. 4927770).
First, a diffusion control mask is formed as a mask on the entirety of the light receiving surface and the rear surface of the silicon substrate. Here, the diffusion control mask has a function of suppressing impurities from diffusing into a silicon substrate.
Next, a part of the diffusion control mask on the rear surface of the silicon substrate is removed to form an opening portion.
In addition, when a p-type impurity is made to diffuse into the rear surface of the silicon substrate from the opening portion of the diffusion control mask, a p-type impurity diffusion layer is formed only at the opening portion.
Next, after the entirety of the diffusion control mask on the rear surface of the silicon substrate is removed, a diffusion control mask is formed again on the rear surface of the silicon substrate. Then, a part of the diffusion control mask on the rear surface of the silicon substrate is removed, and an n-type impurity is made to diffuse into the rear surface of the silicon substrate from the opening portion. Accordingly, an n-type impurity layer is formed.
Subsequently, when the entirety of the diffusion control mask on the rear surface of the silicon substrate is removed, a p-type impurity diffusion layer and an n-type impurity diffusion layer are formed on the rear surface. Furthermore, a texture structure, an antireflective film, a passivation film, electrodes, or the like are formed, and thereby the rear surface electrode type photovoltaic cell is obtained.

In addition, a method of manufacturing the rear surface electrode type photovoltaic cell using a diffusing agent including an n-type impurity and a diffusing agent including a p-type impurity is disclosed (for example, refer to Japanese Patent Application Laid-Open (JP-A) No. 2009-76546).

### DISCLOSURE OF INVENTION

### Technical Problem

In the manufacturing method disclosed in Specification of US patent No. 4927770, to form the p-type impurity diffusion layer and the n-type impurity diffusion layer on the rear surface, it is necessary to perform a complicated process, that is, to repeatedly perform each process of the formation of the diffusion control mask, the formation of the opening portion, the diffusion of the impurities, and the removal of the diffusion control mask.
In addition, in the manufacturing method disclosed in JP-A No. 2009-76546, the processes of providing and removing the protective layer are necessary, and in addition, the diffusion layer may be formed in unnecessary places depending on the heat treatment conditions at the time of the diffusion.
The present invention has been made in consideration of the problems in the related art, and an object of the present invention is to provide a method for producing a photovoltaic cell, in which, in a process of producing a rear surface electrode type photovoltaic cell, two different kinds of impurity diffusion layers are able to be formed on the same surface by a simple process.

### Solution to Problem

The invention includes the following embodiments.
<1> A method for producing a photovoltaic cell, including: applying, on a first region on one surface of a semiconductor substrate, an n-type diffusion layer forming composition including an n-type impurity-containing glass powder and a dispersion medium; applying, on a second region other than the first region on the surface of the semiconductor substrate where the first region is provided, a p-type diffusion layer forming composition including a p-type impurity-containing glass powder and a dispersion medium; performing a thermal diffusion process in which an n-type diffusion layer and a p-type diffusion layer are formed by heat-treating the semiconductor substrate onto which the n-type diffusion layer forming composition and the p-type diffusion layer forming composition are applied; and forming an electrode in the first region where the n-type diffusion layer is formed and in the second region where the p-type diffusion layer is formed, respectively.

<2> A method for producing a photovoltaic cell, including: applying, on a first region on one surface of a semiconductor substrate, an n-type diffusion layer forming composition including an n-type impurity-containing glass powder and a dispersion medium; applying, on a second region other than the first region on the surface of the semiconductor substrate where the first region is provided, a p-type diffusion layer forming composition including a p-type impurity-containing glass powder and a dispersion medium; performing a thermal diffusion process in which an n-type diffusion layer and a p-type diffusion layer are formed by heat-treating the semiconductor substrate onto which the n-type diffusion layer forming composition and the p-type diffusion layer forming composition are applied; providing a protective layer in at least one region selected from the first region, the second region, or a third region other than the first and second regions, on the surface of the semiconductor substrate where the first and second regions are formed, before performing the thermal diffusion process; and forming an electrode in the first region where the n-type diffusion layer is formed and in the second region where the p-type diffusion layer is formed, respectively.

<3> The method for producing a photovoltaic cell according to <2>, wherein an oxide film is provided as the protective layer.

<4> The method for producing a photovoltaic cell according to any one of <1> to <3>, wherein the n-type impurity includes at least one element selected from the group consisting of P (phosphorus) and Sb (antimony).

<5> The method for producing a photovoltaic cell according to any one of <1> to <4>, wherein the p-type impurity includes at least one element selected from the group consisting of B (boron), Al (aluminum) and Ga (gallium).

<6> The method for manufacturing a photovoltaic cell according to any one of <1> to <5>, wherein the n-type impurity-containing glass powder includes: at least one kind of n-type impurity-containing material selected from the group consisting of P₂O₃, P₂O₅, and Sb₂O₃, and at least one glass component material selected from the group consisting of SiO₂, K₂O, Na₂O, Li₂O, BaO, SrO, CaO, MgO, BeO, ZnO, PbO, CdO, V₂O₅, SnO, ZrO₂, TiO₂ and MoO₃.

<7> The method for producing a photovoltaic cell according to any one of <1> to <6>, wherein the p-type impurity-containing glass powder includes: at least one p-type impurity-containing material selected from the group consisting of B₂O₃, Al₂O₃ and Ga₂O₃, and at least one glass component material selected from the group consisting of SiO₂, K₂O, Na₂O, Li₂O, BaO, SrO, CaO, MgO, BeO, ZnO, PbO, CdO, V₂O₅, SnO, ZrO₂, TiO₂ and MoO₃.

### Advantageous Effects of Invention

According to the present invention, there can be provided a method for producing a photovoltaic cell, in which, in a process of producing a rear surface electrode type photovoltaic cell, two different kinds of impurity diffusion layers are able to be formed on the same surface by a simple process.

### BEST MODE FOR CARRYING OUT THE INVENTION

The term "process" as used herein encompasses not only an independent process but also a process in which the anticipated effect of this process is achieved, even if the process cannot be clearly distinguished from another process. In addition, "from...to..." denotes a range including each of the minimum value and the maximum value of the values described in this expression. Unless specifically indicated, in a case in which each ingredient of a composition includes plural materials, the content of each ingredient of the composition denotes the total amount of the plural materials included in the composition.

According to a first aspect of the invention, a method for producing a photovoltaic cell includes a process of applying an n-type diffusion layer forming composition including an n-type impurity-containing glass powder and a dispersion medium on a first region on one surface side of a semiconductor substrate; a process of applying a p-type diffusion layer forming composition including a p-type impurity-containing glass powder and a dispersion medium on a second region other than the first region on the surface of the semiconductor substrate where the first region is provided; a thermal diffusion process in which an n-type diffusion layer and a p-type diffusion layer are formed by heat-treating the semiconductor substrate on which the n-type diffusion layer forming composition and the p-type diffusion layer forming composition are applied; a process of forming an electrode in each of the first region where the n-type diffusion layer is formed and the second region where the p-type diffusion layer is formed, respectively; and optionally, other process as necessary.
The heat treatment is performed after the n-type diffusion layer forming composition and the p-type diffusion layer forming composition are applied to the first region and the second region, respectively. Therefore, the n-type impurity diffuses into the semiconductor substrate from the n-type diffusion layer forming composition and thereby the n-type diffusion layer is formed in the first region. In addition, the p-type impurity diffuses into the semiconductor substrate from the p-type diffusion layer forming composition, and thereby the p-type diffusion layer is formed in the second region. The n-type diffusion layer and the p-type diffusion layer are formed to have a desired shape with good precision. In addition, it is possible to suppress the formation of the n-type diffusion layer or the p-type diffusion layer in a third region other than the first and second regions.

According to a second aspect of the present invention, a method for producing a photovoltaic cell includes a process of applying an n-type diffusion layer forming composition including an n-type impurity-containing glass powder and a dispersion medium on a first region on one surface side of a semiconductor substrate; a process of applying a p-type diffusion layer forming composition including a p-type impurity-containing glass powder and a dispersion medium on a second region other than the first region on the surface of the semiconductor substrate where the first region is provided; a thermal diffusion process in which an n-type diffusion layer and a p-type diffusion layer are formed by heat-treating the semiconductor substrate on which the n-type diffusion layer forming composition and the p-type diffusion layer forming composition are applied; a process of providing a protective layer in at least one region selected from the first region, the second region, or a third region other than the first and second regions on the surface of the semiconductor substrate where the first and second regions are formed, before the thermal diffusion process; a process of forming an electrode in the first region where the n-type diffusion layer is formed and in the second region where the p-type diffusion layer is formed, respectively; and optionally, other processes as necessary.
When the protective layer is provided before the thermal diffusion process, it is possible to more effectively suppress the formation of the n-type diffusion layer or the p-type diffusion layer in the third region other than the first and second regions.

Hereinafter, the n-type diffusion layer forming composition and the p-type diffusion layer forming composition of the present invention will be described, and then the method for producing a rear surface electrode type photovoltaic cell using the n-type diffusion layer forming composition and the p-type diffusion layer forming composition will be described.

### [n-Type Diffusion Layer Forming Composition]

The n-type diffusion layer forming composition includes at least one kind of an n-type impurity-containing glass powder, and at least one kind of dispersion medium, and may optionally include other additives in consideration of such things as the application properties.
Here, the n-type diffusion layer forming composition represents a material that includes an n-type impurity and that is able to form an n-type diffusion layer through an application onto a silicon substrate and a thermal diffusion of the n-type impurity. When the n-type diffusion layer forming composition is used, the n-type diffusion layer is formed at a desired portion.

### (n-Type Impurity-containing Glass Powder)

The term "n-type impurity" included in the glass powder refers to an element which is capable of forming an n-type diffusion layer by doping thereof on a silicon substrate. As the n-type impurity, elements of Group XV of the periodic table can be used. Examples of the n-type impurity include P (phosphorous), Sb (antimony), Bi (bismuth), and As (arsenic). From the aspect of safety, convenience of vitrification or the like, P or Sb is preferable.
Examples of the n-type impurity-containing material which is used for introducing the n-type impurity into the glass powder include P₂O₃, P₂O₅, Sb₂O₃, Bi₂O₃, and As₂O₃. At least one selected from P₂O₃, P₂O₅, and Sb₂O₃ is preferably used.
Further, the melting temperature, softening point, glass-transition point, chemical durability or the like of the glass powder can be controlled by adjusting the component ratio, if necessary. Further, the glass powder preferably contains the components mentioned below.

Examples of the glass component material include SiO₂, K₂O, Na₂O, Li₂O, BaO, SrO, CaO, MgO, BeO, ZnO, PbO, CdO, V₂O₅, SnO, ZrO₂, WO₃, MoO₃, MnO, La₂O₃, Nb₂O₅, Ta₂O₅, Y₂O₃, TiO₂, ZrO₂, GeO₂, TeO₂, and Lu₂O₃. At least one selected from SiO₂, K₂O, Na₂O, Li₂O, BaO, SrO, CaO, MgO, BeO, ZnO, PbO, CdO, V₂O₅, SnO, ZrO₂, TiO₂, and MoO₃ is preferably used.
Specific examples of the n-type impurity-containing glass powder include materials including both the n-type impurity-containing material and the glass component material, for example, P₂O₅ based glass which includes P₂O₅ as the n-type impurity-containing material such as P₂O₅-SiO₂ (the n-type impurity-containing material and the glass component material are listed in this order, and are listed in the same order below)-based glass, P₂O₅-K₂O-based glass, P₂O₅-Na₂O-based glass, P₂O₅-Li₂O-based glass, P₂O₅-BaO-based glass, P₂O₅-SrO-based glass, P₂O₅-CaO-based glass, P₂O₅-MgO-based glass, P₂O₅-BeO-based glass, P₂O₅-ZnO-based glass, P₂O₅-CdO-based glass, P₂O₅-PbO-based glass, P₂O₅-V₂O₅-based glass, P₂O₅-SnO-based glass, P₂O₅-GeO₂-based glass, and P₂O₅-TeO₂-based glass; Sb₂O₃ based glass in which P₂O₅ is replaced by Sb₂O₃ as an n-type impurity-containing material in the P₂O₅ based glass.
The n-type impurity-containing glass powder may include two or more n-type impurity-containing materials such as P₂O₅-Sb₂O₃, P₂O₅-As₂O₃ or the like
Although composite glass containing two components has been exemplified in the above, glass powder containing three or more components, such as P₂O₅-SiO₂-V₂O₅ or P₂O₅-SiO₂-CaO, may also be used as necessary.

The content of the glass component material in the n-type impurity-containing glass powder is preferably appropriately set taking into consideration the melting temperature, the softening point, the glass-transition point, and chemical durability. Generally, the content of the glass component material is preferably from 0.1% by mass to 95% by mass, and more preferably from 0.5% by mass to 90% by mass.
Specifically, in case of P₂O₅-SiO₂-CaO-based glass, the content of CaO is preferably from 1% by mass to 30% by mass, and more preferably from 5% by mass to 20% by mass.

The softening point of the n-type impurity-containing glass powder is preferably in the range of from 200°C to 1000°C, and more preferably from 300°C to 900°C, from the aspect of diffusivity and dripping during the diffusion treatment.
The shape of the glass powder includes a substantially spherical shape, a flat shape, a block shape, a plate shape, a scale-like shape, and the like. From the aspect of the coating property and uniform dispersion property, it is preferably a spherical shape, a flat shape, or a plate shape.
The average particle diameter of the glass powder is preferably 100 µm or less. When a glass powder having an average particle diameter of 100 µm or less is used, a smooth coated film can be easily obtained. Further, the average particle diameter of the glass powder is more preferably 50 µm or less and further more preferably 10 µm or less. The lower limit of the average particle diameter is not particularly limited, and preferably 0.01 µm or more.
The average particle diameter of the glass powder means the mean volume particle diameter, and may be measured by laser diffraction particle size analyzer.

The n-type impurity-containing glass powder is prepared according to the following procedure.
First, raw materials are weighed and placed in a crucible. Examples of the material for the crucible include platinum, platinum-rhodium, iridium, alumina, quartz and carbon, which are appropriately selected taking into consideration the melting temperature, atmosphere, reactivity with melted materials, and the like.
Next, the raw materials are heated to a temperature corresponding to the glass composition in an electric furnace, thereby preparing a solution. At this time, stirring is preferably applied such that the solution becomes homogenous.
Subsequently, the obtained solution is allowed to flow on a zirconia substrate, a carbon substrate or the like to result in vitrification of the solution.
Finally, the glass is pulverized into a powder. The pulverization can be carried out by using a known method such as using a jet mill, a bead mill, or a ball mill.

The content of the n-type impurity-containing glass powder in the n-type diffusion layer forming composition is determined taking into consideration coatability, diffusivity of n-type impurities, and the like. Generally, the content of the glass powder in the n-type diffusion layer forming composition is preferably from 0.1% by mass to 95% by mass, more preferably from 1% by mass to 90% by mass, still more preferably from 1.5% by mass to 85% by mass, and further more preferably from 2% by mass to 80% by mass.

### (Dispersion Medium)

Hereinafter, a dispersion medium will be described.
The dispersion medium is a medium which disperses the glass powder in the composition. Specifically, a binder, a solvent or the like is employed as the dispersion medium.

### - Binder -

For example, the binder may be appropriately selected from a polyvinyl alcohol, polyacrylamides, polyvinyl amides, polyvinyl pyrrolidone, polyethylene oxides, polysulfonic acid, acrylamide alkyl sulfonic acid, cellulose derivatives such as cellulose ethers, carboxymethylcellulose, hydroxyethylcellulose, ethylcellulose, gelatin, starch and starch derivatives, sodium alginates, xanthane and xanthane derivatives, guar and guar derivatives, scleroglucan and scleroglucan derivatives, tragacanth and tragacanth derivatives, dextrin and dextrin derivatives, (meth)acrylic acid resins, (meth)acrylic acid ester resins (for example, alkyl (meth)acrylate resins, dimethlaminoethyl (meth)acrylate resins, or the like), butadiene resins, styrene resins, and copolymers thereof, siloxane resins, and the like. These compounds may be used individually or in a combination of two or more thereof.
The molecular weight of the binder is not particularly limited and is preferably appropriately adjusted taking into consideration the desired viscosity of the composition.

### - Solvent -

Examples of the solvent include ketone solvents such as acetone, methylethylketone, methyl-n-propylketone, methyl-iso-propylketone, methyl-n-butylketone, methyl-iso-butylketone, methyl-n-pentylketone, methyl-n-hexylketone, diethylketone, dipropylketone, di-iso-butylketone, trimethylnonanone, cyclohexanone, cyclopentanone, methylcyclohexanone, 2,4-pentanedione, and acetonylacetone; ether solvents such as diethyl ether, methyl ethyl ether, n-di-n-propyl ether, di-iso-propyl ether, tetrahydrofuran, methyl tetrahydrofuran, dioxane, dimethyl dioxane, ethylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl n-propyl ether, diethylene glycol methyl n-butyl ether, diethylene glycol di-n-propyl ether, diethylene glycol di-n-butyl ether, diethylene glycol methyl n-hexyl ether, triethylene glycol dimethyl ether, triethylene glycol diethyl ether, triethylene glycol methyl ethyl ether, triethylene glycol methyl n-butyl ether, triethylene glycol di-n-butyl ether, triethylene glycol methyl n-hexyl ether, tetraethylene glycol dimethyl ether, tetraethylene glycol diethyl ether, tetradiethylene glycol methyl ethyl ether, tetraethylene glycol methyl n-butyl ether, tetraethylene glycol di-n-butyl ether, tetraethylene glycol methyl n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl n-butyl ether, dipropylene glycol di-n-propyl ether, dipropylene glycol di-n-butyl ether, dipropylene glycol methyl n-hexyl ether, tripropylene glycol dimethyl ether, tripropylene glycol diethyl ether, tripropylene glycol methyl ethyl ether, tripropylene glycol methyl n-butyl ether, tripropylene glycol di-n-butyl ether, tripropylene glycol methyl n-hexyl ether, tetrapropylene glycol dimethyl ether, tetrapropylene glycol diethyl ether, tetradipropylene glycol methyl ethyl ether, tetrapropylene glycol methyl n-butyl ether, tetrapropylene glycol di-n-butyl ether, tetrapropylene glycol methyl n-hexyl ether, and tetrapropylene glycol di-n-butyl ether; ester solvents such as methyl acetate, ethyl acetate, n-propyl acetate, i-propyl acetate, n-butyl acetate, i-butyl acetate, sec-butyl acetate, n-pentyl acetate, sec-pentyl acetate, 3-methoxybutyl acetate, methyl pentyl acetate, 2-ethyl butyl acetate, 2-ethyl hexyl acetate, 2-(2-butoxyethoxy)ethyl acetate, benzyl acetate, cyclohexyl acetate, methyl cyclohexyl acetate, nonyl acetate, methyl acetoacetate, ethyl acetoacetate, glycol diacetate, methoxy triglycol acetate, ethyl propionate, n-butyl propionate, i-amyl propionate, diethyl oxalate, di-n-butyl oxalate, methyl lactate, ethyl lactate, n-butyl lactate, n-amyl lactate, γ-butyrolactone, and γ-valerolactone; ether acetate solvents such as ethylene glycol methyl ether propionate, ethylene glycol ethyl ether propionate, ethylene glycol methyl ether acetate, ethylene glycol ethyl ether acetate, diethylene glycol methyl ether acetate, diethylene glycol ethyl ether acetate, diethylene glycol-n-butyl ether acetate, propylene glycol methyl ether acetate, propylene glycol ethyl ether acetate, propylene glycol propyl ether acetate, dipropylene glycol methyl ether acetate, and dipropylene glycol ethyl ether acetate; aprotic polar sovents such as acetonitrile, N-methyl pyrrolidinone, N-ethyl pyrrolidinone, N-propyl pyrrolidinone, N-butyl pyrrolidinone, N-hexyl pyrrolidinone, N-cyclohexyl pyrrolidinone, N,N-dimethyl formamide, N,N-dimethyl acetamide, and dimethyl sulfoxide; alcohol solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxy butanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, phenol, cyclohexanol, methylcyclohexanol, benzyl alcohol, ethylene glycol, 1,2-propylene glycol, 1,3-butylene glycol, diethylene glycol, dipropylene glycol, triethylene glycol, and tripropylene glycol; glycol monoether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether, and tripropylene glycol monomethyl ether; terpene solvents such as α-terpinene, α- terpinenol, myrcene, allo-ocimene, limonene, dipentene, α-dipentene, β-dipentene, terpinenol, carvone, ocimene, and phellandrene; water, and the like. These solvents may be used individually or in a combination of two or more thereof. From the aspect of the coating property of the composition for forming an n-type diffusion layer at a substrate, α-terpinenol, diethylene glycol mono-n-butyl ether, and 2-(2-butoxyethoxy)ethyl acetate is preferable.

The content of the dispersion medium in the n-type diffusion layer forming composition is determined taking into consideration coatability and n-type impurity concentration.
The viscosity of the n-type diffusion layer forming composition is preferably from 10 mPa·s to 1,000,000 mPa·s, and more preferably from 50 mPa·s to 500,000 mPa·s, from the aspect of coatability.

### [p-Type Diffusion Layer Forming Composition]

The p-type diffusion layer forming composition includes at least one kind of p-type impurity-containing glass powder, and at least one kind of dispersion medium, and may optionally include other additives in consideration of the coating properties.
Here, the p-type diffusion layer forming composition represents a material that includes a p-type impurity and that is able to form a p-type diffusion layer through being applied onto a silicon substrate and then thermally diffusing the p-type impurity. When the p-type diffusion layer forming composition is used, the p-type diffusion layer is formed at a desired portion.
Since a p-type impurity component in the glass powder is hardly volatilized even during sintering, a p-type diffusion layer is prevented from also being formed on the rear surface or side face, rather than on the front surface alone due to the generation of volatile gases. It is assumed that the reason for this is that the p-type impurity component combines with an element in a glass powder, or is absorbed into the glass, as a result of which the p-type impurity component is hardly volatilized.

### (p-Type Impurity-containing Glass Powder)

The term "p-type impurity" included in the glass powder refers to an element which is capable of forming a p-type diffusion layer by doping thereof on a silicon substrate. As the p-type impurity, elements of Group XIII of the periodic table can be used. Examples of the p-type impurity include B (boron), Al (aluminum), and Ga (gallium).
Examples of the p-type impurity-containing material include B₂O₃, Al₂O₃, and Ga₂O₃. At least one selected from B₂O₃, Al₂O₃, and Ga₂O₃ is preferably used.
Further, the melting temperature, softening point, glass-transition point, chemical durability or the like of the glass powder can be controlled by adjusting the component ratio, if necessary. Further, the glass powder preferably contains the components mentioned below.

Examples of the glass component material include SiO₂, K₂O, Na₂O, Li₂O, BaO, SrO, CaO, MgO, BeO, ZnO, PbO, CdO, Tl₂O, V₂O₅, SnO, ZrO₂, WO₃, MoO₃, MnO, La₂O₃, Nb₂O₅, Ta₂O₅, Y₂O₃, TiO₂, GeO₂, TeO₂, and Lu₂O₃. At least one selected from SiO₂, K₂O, Na₂O, Li₂O, BaO, SrO, CaO, MgO, BeO, ZnO, PbO, CdO, V₂O₅, SnO, ZrO₂, TiO₂, and MoO₃ is preferably used.
Specific examples of the p-type impurity-containing glass powder include those including both the p-type impurity-containing material and the glass component material such as, for example, B₂O₃ based glass which includes B₂O₃ as the p-type impurity such as B₂O₃-SiO₂ (the p-type impurity-containing material and the glass component material are listed in this order, and are listed in the same order below) based glass, B₂O₃-ZnO based glass, B₂O₃-PbO based glass, single B₂O₃ based glass; Al₂O₃ based glass which includes Al₂O₃ as the acceptor element such as Al₂O₃-SiO₂ based glass; and Ga₂O₃ based glass which includes Ga₂O₃ as the acceptor element such as Ga₂O₃-SiO₂ based glass.
The p-type impurity-containing glass powder may include two or more p-type impurity-containing materials such as Al₂O₃- B₂O₃, Ga₂O₃- B₂O₃ or the like.
Although composite glasses containing one or two components have been exemplified in the above, glass powder containing three or more components, such as B₂O₃-SiO₂-Na₂O, may also be used as necessary.

The content of the glass component material in the p-type impurity-containing glass powder is preferably appropriately set taking into consideration the melting temperature, the softening point, the glass-transition point, and chemical durability. Generally, the content of the glass component material is preferably from 0.1% by mass to 95% by mass, and more preferably from 0.5% by mass to 90% by mass.

The softening point of the p-type impurity-containing glass powder is preferably in the range of from 200°C to 1000°C, and more preferably from 300°C to 900°C, from the aspect of diffusivity and dripping during the diffusion treatment.
The shape of the glass powder includes a substantially spherical shape, a flat shape, a block shape, a plate shape, a scale-like shape, and the like. From the aspect of coating property and uniform dispersion property, it is preferably a spherical shape, a flat shape, or a plate shape. The average particle diameter of the glass powder is preferably 100 µm or less. When a glass powder having an average particle diameter of 100 µm or less is used, a smooth coated film can be easily obtained. Further, the average particle diameter of the glass powder is more preferably 50 µm or less and further more preferably 10 µm or less.. The lower limit of the average particle diameter is not particularly limited, and preferably 0.01 µm or more.

The p-type impurity-containing glass powder is prepared according to the same procedure described in the n-type impurity-containing glass powder.

The content of the p-type impurity-containing glass powder in the p-type diffusion layer forming composition is determined taking into consideration coatability, diffusivity of n-type impurities, and the like. Generally, the content of the glass powder in the p-type diffusion layer forming composition is preferably from 0.1% by mass to 95% by mass, more preferably from 1% by mass to 90% by mass, still more preferably from 1.5% by mass to 85% by mass, and further more preferably from 2% by mass to 80% by mass.

As the dispersion medium, the same material described in the n-type diffusion layer forming composition may be used.
The content of the dispersion medium in the p-type diffusion layer forming composition is determined taking into consideration coatability and p-type impurity concentration.
The viscosity of the p-type diffusion layer forming composition is preferably from 10 mPa·s to 1,000,000 mPa·s, and more preferably from 50 mPa·s to 500,000 mPa·s, from the aspect of coatability.

### [Method for Producing Photovoltaic Cell]

First, a damage layer on the surface of the silicon substrate is removed through etching using an acidic or alkalic solution.
Next, a protective film formed of a silicon oxide film or a silicon nitride film on one surface side of the silicon substrate is formed. Here, the silicon oxide film may be formed, for example, by a normal pressure CVD method using silane gas and oxygen. In addition, the silicon nitride film may be formed, for example, by a plasma CVD method using silane gas, ammonia gas, and nitrogen gas.

Next, a minute concavo-convex structure called a texture structure is formed on the surface of the side where the protective film of the silicon substrate is not formed. The texture structure may be formed, for example, by immersing the silicon substrate on which the protective film is formed in liquid including potassium hydroxide and isopropyl alcohol (IPA) at approximately 80°C.
Subsequently, the silicon substrate is immersed in a hydrofluoric acid and thereby the protective film is etched and removed.
The above described process of texture structure forming may be performed after a diffusion layer described later is formed.

Next, the n-type diffusion layer and the p-type diffusion layer are selectively formed in the first region and the second region on the same plane of the silicon substrate, respectively.
The shape and size of the first region and the second region are not particularly limited, but may be appropriately selected from the shape and size of the n-type diffusion layer and the p-type diffusion layer that are commonly adopted in the rear surface electrode type photovoltaic cell.

Specifically, for example, the n-type diffusion layer forming composition is applied onto the first region on a surface (hereinafter, referred to as "rear surface") that is opposite to the surface serving as the light receiving surface of the silicon substrate. The shape and size of the first region is appropriately selected according to, for example, the shape and size of the n-type diffusion layer that is formed. As the shape, for example, a line shape may be exemplified. In addition, the line width may be, for example, from 100 µm to 300 µm.
In addition, the p-type diffusion layer forming composition is applied onto the second region on the rear surface of the silicon substrate. The shape and size of the second region is appropriately selected according to, for example, the shape and size of the p-type diffusion layer that is formed. As the shape, for example, a line shape may be exemplified. In addition, the line width may be, for example, from 500 µm to 900 µm.

It is preferable that the first region and the second region be provided with a predetermined interval without being brought into contact with each other. The interval between the first region and the second region may be appropriately selected according to various physical properties of the n-type diffusion layer forming composition and the p-type diffusion layer forming composition. For example, the interval may be set to from 1 mm to 3 mm.
When the predetermined interval is provided in the first region and the second region, it is possible to improve a power generation efficiency of the rear surface electrode type photovoltaic cell that is constructed.

In addition, the sequence of applying the n-type diffusion layer forming composition and the p-type diffusion layer forming composition is not particularly limited. That is, after the n-type diffusion layer forming composition is applied onto the first region, the p-type diffusion layer forming composition may be applied onto the second region. In addition, after the p-type diffusion layer forming composition is applied onto the second region, the n-type diffusion layer forming composition may be applied onto the first region. Furthermore, the n-type diffusion layer forming composition and the p-type diffusion layer forming composition may be applied at the same time depending on the application method.

The method of applying the n-type diffusion layer forming composition and the p-type diffusion layer forming composition is not particularly limited, but a commonly used method may be used. For example, a printing method such as a screen printing method and a gravure printing method, a spinning method, a brush coating, a spraying method, a doctor blade method, a roll coater method, an ink jet method, or the like may be used. Furthermore, the method of applying the n-type diffusion layer forming composition and the p-type diffusion layer forming composition may be the same as each other or be different from each other.
There is no particular limit to the application amount of the n-type diffusion layer forming composition and the p-type diffusion layer forming composition. For example, an amount of the glass powder may be set to from 0.01 g/m² to 100 g/m², and more preferably from 0.1 g/m² to 10 g/m². Here, the application amount of n-type diffusion layer forming composition and the application amount of p-type diffusion layer forming composition may be independently and appropriately selected according to the construction of the n-type diffusion layer forming composition and the p-type diffusion layer forming composition, or the impurity concentration in the n-type diffusion layer and the p-type diffusion layer that are formed, respectively.

After the n-type diffusion layer forming composition and the p-type diffusion layer forming composition are applied onto the silicon substrate, a heating process of removing at least a part of the dispersion medium may be provided. In the heating process, for example, when a heating treatment is performed at from 100°C to 200°C, it is possible to volatilize at least part of a solvent. In addition, for example, at least a part of a binder may be removed through a heating treatment at from 200°C to 500°C.
The heating process may be performed after applying either the n-type diffusion layer forming composition or the p-type diffusion layer forming composition, or may be performed after applying both of these compositions.

Next, when the silicon substrate onto which the n-type diffusion layer forming composition and the p-type diffusion layer forming composition are applied is heat-treated, the n-type diffusion layer and the p-type diffusion layer are formed. Through the heat treatment, the n-type impurity diffuses into the silicon substrate from the n-type diffusion layer forming composition applied onto the first region, and the p-type impurity diffuses into the silicon substrate from the p-type diffusion layer forming composition applied onto the second region, and thereby the n-type diffusion layer and the p-type diffusion layer are formed.
In the present invention, the n-type diffusion layer forming composition and p-type diffusion layer forming composition are used, such that it is possible to form the n-type diffusion layer and the p-type diffusion layer to have a desired shape with an excellent precision. Furthermore, even when a protective layer described later is not provided, it is possible to suppress the formation of the n-type diffusion layer and the p-type diffusion layer in a region where the diffusion is not necessary.
The temperature of the heat treatment is not particularly limited as long as the n-type diffusion layer and the p-type diffusion layer can be formed, but it is preferable that the temperature be from 800°C to 1100°C, more preferably from 850°C to 1100°C, and further more preferably from 900°C to 1100°C.

As described above, a glass layer remains on the silicon substrate on which the n-type diffusion layer and the p-type diffusion layer are formed, but it is preferable to remove the glass layer. For the removal of the glass layer, a known method such as a method of immersing the silicon substrate in an acid such as a hydrofluoric acid, and a method of immersing the silicon substrate in an alkali, such as sodium hydroxide, may be applied.

In the present invention, before the heat treatment process of forming the n-type diffusion layer and the p-type diffusion layer, the protective layer may be formed in at least a part of the rear surface of the silicon substrate. When the protective layer is provided, it is possible to effectively suppress the formation of the diffusion layer through a diffusion of the n-type impurity or the p-type impurity into a region other than a desired region.
The protective layer may be formed on at least one region selected from the first region, the second region, or a third region other than the first and second regions on a rear surface of the silicon substrate. That is, the protective layer is provided in at least one of first region onto which the n-type diffusion layer forming composition is applied and the second region onto which the p-type diffusion layer forming composition is applied, and on the third region, or the entirety of the rear surface.
Here, in a case where the protective layer is provided in the third region, the protective layer may be provided before the n-type diffusion layer forming composition or the p-type diffusion layer forming composition is applied.

The protective layer is not particularly limited as long as it has a function of suppressing the invasion of the n-type impurity and the p-type impurity, which are scattered by the heating treatment, into a region other than a desired region on the silicon substrate, but it is preferable to use a silicon oxide. Here, the silicon oxide film used as the protective layer may be formed by applying a paste including a silicon compound, an organic solvent, and a thickener through a spin coat, a screen printing method, a gravure printing method, ink jet printing method, or the like.
In addition, it is possible to form the protective layer formed of a silicon oxide using silane gas and oxygen gas through an atmospheric pressure CVD method.

It is preferable to remove the protective layer after the heat treatment for forming the n-type diffusion layer and the p-type diffusion layer. For example, in a case where the protective layer is formed of a glass layer, for the removal of the protective layer, a known method such as a method of immersing the substrate in an acid such as a hydrofluoric acid, and a method of immersing the substrate in an alkali such as sodium hydroxide may be exemplified. In addition, at the time of removing the protective layer, a glass layer derived from the n-type diffusion layer forming composition and the p-type diffusion layer forming composition may be removed at the same time.

After the n-type diffusion layer and the p-type diffusion layer are formed, it is preferable to form a passivation film on the silicon substrate at the rear surface side. Here, as the passivation film, a silicon oxide film, a silicon nitride film, a laminated film thereof, or the like may be used. The silicon oxide film making up the passivation film may be formed through, for example, a thermal oxidation method or an atmospheric pressure CVD method, and the silicon nitride film making up the passivation film may be formed through, for example, a plasma CVD method. In addition, before the passivation film is formed, the rear surface of the silicon substrate may be cleaned by a method that is well known in the related art.

Next, it is preferable to form an antireflective film on a surface of the silicon substrate at the side where a texture structure is formed. Here, as the antireflective film, for example, a nitride film formed through a plasma CVD method may be used.

Next, electrodes are formed on the n-type diffusion layer and the p-type diffusion layer formed as described above, respectively.
Specifically, for example, a part of the passivation film formed on the rear surface is removed, and thereby a part of the surface of the n-type diffusion layer and the p-type diffusion layer is exposed, respectively. Here, for the removal of the passivation film, a method that is well known in the related art may be used.
In addition, when an n-electrode is formed on the surface of the exposed n-type diffusion layer, and a p-electrode is formed on the surface of the exposed p-type diffusion layer, a rear surface electrode type photovoltaic cell is manufactured. The n-electrode and the p-electrode may be formed by applying a silver-containing electrode material onto the exposed surface of the n-type diffusion layer and the p-type diffusion layer, respectively, and by drying and/or baking the electrode material. In addition to this, the n-electrode and the p-electrode may be formed through a vapor deposition method.

In the present invention, the n-type impurity and the p-type impurity are vitrified, such that it is possible to suppress the diffusion of the n-type impurity and the p-type impurity into a region in which the diffusion is unnecessary at the time of forming the diffusion layer. Furthermore, the suppressing effect may be further improved by forming a protective film.

### [EXAMPLES]

Hereinafter, the present invention will be described in detail with reference to examples, but the present invention is not limited to the examples. In addition, if not particularly mentioned, as chemicals, a reagent is used as a whole. In addition, "part" and "%" are based on a mass.

### [Example 1]

A glass powder (including P₂O₅, SiO₂, and CaO as main components at contents of 50%, 43%, and 7%, respectively) which has a substantially spherical particle shape, an average particle diameter of 0.25 µm, and a softening point of approximately 800°C, ethyl cellulose, and terpineol, in an amount of 10 g, 4 g, and 86 g, respectively, are blended and made into a paste and thereby the n-type diffusion layer forming composition was prepared.
Subsequently, a glass powder (including B₂O₃, SiO₂, CaO, MgO, BaO as main components at contents of 30%, 40%, 10%, 10%, and 10%, respectively) which has a substantially spherical particle shape, an average particle diameter of 1.5 µm, and a softening point of approximately 800°C, ethyl cellulose, and terpineol, in an amount of 20g, 4g, and 76g, respectively, are blended and made into a paste and thereby the p-type diffusion layer forming composition was prepared.

The particle shape of the glass powder was judged by observation with a TM-1000 type scanning electron microscope, manufactured by Hitachi High-Technologies Corporation. The average diameter of the glass powder was calculated with a LS 13 320 type laser diffraction particle size analyzer (measurement wave length: 632 nm), manufactured by Beckman Coulter, Inc. The softening point of the glass powder was measured by a differential thermal analysis (DTA) curve with a DTG-60H type Thermo Gravimetry Differential Thermal Analyzer, manufactured by SHIMADZU CORPORATION.

Next, the n-type diffusion layer forming composition was applied in a line shape onto a surface of the silicon substrate through screen printing, and the applied composition was dried at 150°C for 10 minutes. Subsequently, the p-type diffusion layer forming composition was applied in a line shape onto the same surface of the silicon substrate through a screen printing, with a distance from the region where the n-type diffusion layer forming composition was applied, and the applied composition was dried at 150°C for 10 minutes. Then, a binder removal treatment was performed at 350°C for 3 minutes.
Next, a heat treatment was performed in an atmosphere at 950°C for 10 minutes, and thereby the n-type impurity and the p-type impurity were made to diffuse into the silicon substrate. Accordingly, the n-type diffusion layer and the p-type diffusion layer were formed.
Subsequently, the glass layer remaining on the surface of the silicon substrate was removed by a hydrofluoric acid.

Next, the diffusion state of the impurity of the silicon substrate was confirmed through an SIMS measurement. Through the measurement, it was confirmed that in a portion where the n-type diffusion layer forming composition was applied, P (phosphorus) diffused to a distance of approximately 0.7 µm from the surface. In addition, it was confirmed that in a portion where the p-type diffusion layer forming composition was applied, B (boron) diffused to a distance of approximately 0.6 µm from the surface. On the contrary, in a portion where the diffusion layer forming composition was not applied, P (phosphorus) and B (boron) did not diffuse.
The SIMS measurement was performed using an IMS-7F manufactured by CAMECA SAS, in which O₂⁺ and Cs⁺ were used as primary ions.

### [Example 2]

In Example 1, the n-type diffusion layer and the p-type diffusion layer were formed similarly to Example 1 except that after the binder removal treatment, a silicon oxide film as a protective film was formed on the entirety of the application surface of the diffusion layer forming composition through an atmospheric pressure CVD method with a thickness of 300 nm, and then a heat treatment was performed in a nitrogen atmosphere. Subsequently, the glass layer remaining on the surface of the silicon substrate was removed by a hydrofluoric acid.
Next, as described above, the diffusion state of the impurity of the silicon substrate was confirmed through an SIMS measurement. Through the measurement, it was confirmed that in a portion where the n-type diffusion layer forming composition was applied, P (phosphorus) diffused to a distance of approximately 0.7 µm from the surface. In addition, it was confirmed that in a portion where the p-type diffusion layer forming composition was applied, B (boron) diffused to a distance of approximately 0.6 µm from the surface. On the contrary, in a portion where the diffusion layer forming composition was not applied, P (phosphorus) and B (boron) did not diffuse.

### [Manufacturing Photovoltaic Cell]

Using the silicon substrate obtained as described above in which the n-type diffusion layer and the p-type diffusion layer were formed, an n-electrode was formed on the n-type diffusion layer and the p-electrode was formed on the p-type diffusion layer, respectively, through a normal method, and thereby a rear surface electrode type photovoltaic cell was manufactured. The obtained rear surface electrode type photovoltaic cell showed excellent photo-conversion characteristics.

The disclosures of Japanese Patent Application No. 2010-257167 are incorporated by reference herein in their entireties. All the literature, patent applications, and technical standards cited herein are also herein incorporated to the same extent as provided for specifically and severally with respect to an individual literature, patent application, and technical standard to the effect that the same should be so incorporated by reference.

## Claims

1. A method for producing a photovoltaic cell, comprising:
applying, on a first region on one surface of a semiconductor substrate, an n-type diffusion layer forming composition including an n-type impurity-containing glass powder and a dispersion medium;
applying, on a second region other than the first region on the surface of the semiconductor substrate where the first region is provided, a p-type diffusion layer forming composition including a p-type impurity-containing glass powder and a dispersion medium;
performing a thermal diffusion process in which an n-type diffusion layer and a p-type diffusion layer are formed by heat-treating the semiconductor substrate onto which the n-type diffusion layer forming composition and the p-type diffusion layer forming composition are applied; and
forming an electrode in the first region where the n-type diffusion layer is formed and in the second region where the p-type diffusion layer is formed, respectively.

2. A method for producing a photovoltaic cell, comprising:
applying, on a first region on one surface of a semiconductor substrate, an n-type diffusion layer forming composition including an n-type impurity-containing glass powder and a dispersion medium;
applying, on a second region other than the first region on the surface of the semiconductor substrate where the first region is provided, a p-type diffusion layer forming composition including a p-type impurity-containing glass powder and a dispersion medium;
performing a thermal diffusion process in which an n-type diffusion layer and a p-type diffusion layer are formed by heat-treating the semiconductor substrate onto which the n-type diffusion layer forming composition and the p-type diffusion layer forming composition are applied;
providing a protective layer in at least one region selected from the first region, the second region, or a third region other than the first and second regions, on the surface of the semiconductor substrate where the first and second regions are formed, before performing the thermal diffusion process; and
forming an electrode in the first region where the n-type diffusion layer is formed and in the second region where the p-type diffusion layer is formed, respectively.

3. The method for producing a photovoltaic cell according to claim 2,
wherein an oxide film is provided as the protective layer.

4. The method for producing a photovoltaic cell according to any one of claims 1 to 3,
wherein the n-type impurity includes at least one element selected from the group consisting of P (phosphorus) and Sb (antimony).

5. The method for producing a photovoltaic cell according to any one of claims 1 to 4,
wherein the p-type impurity includes at least one element selected from the group consisting of B (boron), Al (aluminum) and Ga (gallium).

6. The method for manufacturing a photovoltaic cell according to any one of claims 1 to 5,
wherein the n-type impurity-containing glass powder includes:
at least one n-type impurity-containing material selected from the group consisting of P₂O₃, P₂O₅ and Sb₂O₃, and
at least one glass component material selected from the group consisting of SiO₂, K₂O, Na₂O, Li₂O, BaO, SrO, CaO, MgO, BeO, ZnO, PbO, CdO, V₂O₅, SnO, ZrO₂, TiO₂ and MoO₃.

7. The method for producing a photovoltaic cell according to any one of claims 1 to 6,
wherein the p-type impurity-containing glass powder includes:
at least one p-type impurity-containing material selected from the group consisting of B₂O₃, Al₂O₃ and Ga₂O₃, and
at least one glass component material selected from the group consisting of SiO₂, K₂O, Na₂O, Li₂O, BaO, SrO, CaO, MgO, BeO, ZnO, PbO, CdO, V₂O₅, SnO, ZrO₂, TiO₂ and MoO₃.
